# EUROPEAN PATENT SPECIFICATION

(11) **EP 2 667 690 B1**
(45) Date of publication and mention of the grant of the patent: **11.09.2019**
(21) Application number: 12168996.2
(22) Date of filing: 23.05.2012
(51) Int. Cl.: H05K 1/02, H05K 1/11, H05K 3/00, H05K 3/46, H01R 12/72

(54) **THREE-DIMENSIONAL CIRCUIT BOARD**
DREIDIMENSIONALE LEITERPLATTE
CARTE DE CIRCUIT IMPRIMÉ TRIDIMENSIONNELLE

(43) Date of publication of application: 27.11.2013
(73) Proprietor: Tyco Electronics Belgium EC BVBA, 8020 Oostkamp (BE); Tyco Electronics Nederland B.V., 5222 AR's-Hertogenbosch (NL)
(72) Inventor: Decrock, Lieven, 8800 Roeselare (BE); Smink, Rutger, 3930 Hamont-Achel (BE); Van het Bolscher, Han, 5038 KS Tilburg (NL); Campschroer, Dolf, 6601 XA Wijchen (NL); Van Gils, Wijnand, 4942 CG Raamsdonksveer (NL)
(74) Representative: Patentanwaltskanzlei WILHELM & BECK

(56) References cited:
- EP-A1- 2 410 825
- GB-A- 2 001 484
- JP-A- 2000 183 231
- JP-A- 2006 173 239
- US-A- 6 040 524
- US-A- 6 072 126
- US-A1- 2006 042 821
- US-A1- 2011 195 593

## Description

The present invention relates to three-dimensional circuit boards as defined in the preamble of claim 1.

Electronic connectors and/or connections where a conventional two-dimensional printed circuit board (2D-PCB) is used are well known. Such known 2D-PCBs may be replaced by a three-dimensional circuit board or carrier manufactured by, for example, what is known as a moulded interconnection device (MID) process as set forth in WO 2005/109978 or JP 2000 183231 A. Three-dimensional circuit boards can also be manufactured by other processes well known to the skilled person, such as overmoulding of a lead frame.

Such three-dimensional circuit boards can replace known 2D-PCBs in products such as a connector, a plug, a transmitter, a receiver, a transceiver or being part of an active or passive cable, etc. to mention some. Electrical disadvantages of a 2D-PCB are for example a complicated control of a characteristic impedance and a limited possibility in cross-talk compensation (small form-factor at high data rates).

By using, for example, an MID process to integrate both mechanical (plastic or ceramic component) and electrical (circuit paths, wiring pattern) functionalities into a single solution, one or a plurality of circuit paths are integrated into a three-dimensional carrier component as a substitute for a conventional 2D-PCB.

It is an object of the present invention to provide a three-dimensional circuit board having improved electronic characteristics, such as improved cross-talk and impedance performance.

The object of the invention is achieved by a three-dimensinal circuit board as defined in claim 1 which is characterised in that for impedance control, a carrier body of the three-dimensional circuit board comprises two different planes, wherein at least one circuit path is at least partially arranged in the different planes wherein the three-dimensional circuit board comprises an electrical grounding layer that is arranged below the circuit path and the ground path is connected with an electrical bridge that is guided to the electrical grounding layer, and wherein, for cross-talk control, a mechanical termination portion and/or an electrical termination portion of the carrier component for wires of a cable is staggered, wherein two directly adjacent electrical terminals of the carrier component have the same longitudinal position and an adjacent pair thereto is longitudinally offset to the first pair of terminals.

Further, the object of the invention is achieved by a connector as defined in claim 15. According to the invention, an impedance transition is improved and a return loss of such a three-dimensional circuit is improved too, i. e. goes down.

In a further embodiment, an electrical terminal of the electrical path is arranged on the upper plane of the carrier body. This has the advantage that a contact element that lies on the electrical terminal has a larger distance to the circuit path that is arranged in the lower plane.

In a further embodiment, the carrier component has at least two circuit paths, wherein the two circuit paths may lie at least partially in different planes, wherein the planes may be arranged in parallel or may be inclined to each other.

In a further embodiment, the three-dimensional circuit board may comprise two carrier components, whereby the electrical grounding layer may be sandwiched between the first and the second carrier component.

For controlling or managing an impedance, a way of a signal path is arranged differently than a way of a ground path of the carrier body of the carrier component. For example, a signal path may lie at least partially in the lower plane of the carrier body and a ground path may lie at least partially in the upper plane of the carrier body. Further, a signal path may lie at least partially in a plane that is inclined to the lower and the upper plane.

A ground path may be partially by an electrical bridge or over its entire length in electric contact with the electrical grounding, whereby the ground path is in electric contact with the electrical bridge which may be formed as a via or a bar in the carrier body. The electrical bridge defines an electrical shielding.

For controlling or managing cross-talk, a side edge of the electrical grounding may extend essentially to a side edge of the carrier component.

In a further embodiment, a positioning wall of a wire organiser of the mechanical termination portion is grounded, wherein the positioning wall is electrically conductive, preferably metallised. Since the electrical grounding of the carrier component is extended to the end of the electrical three-dimensional circuit, especially the cross-talk is improved, i. e. goes down.

The carrier component of the inventive three-dimensional circuit board may have a mechanical and an electrical plug portion arranged one behind the other for mechanically and electrically mating with a counter-contact means. Here, an edge, preferably a bevelled edge, of the mechanical plug portion may be staggered, and/or at least parts of the electrical terminals of the circuit paths may lie all in one line with each other. The staggered edge of the carrier component comprises at least two or multiple steps.

For guiding the electric contact elements of the counter-contact means, a guiding wall may be arranged between two directly adjacent terminals. Furthermore, a portion of the edge of the first carrier component may be staggered in comparison to a directly adjacent portion of the edge of the second carrier component.

Further, in embodiments of the invention, a side wall of a deepening of the carrier component is inclined or perpendicular to the upper plane of the carrier component.

In embodiments of the invention, an electrical and/or mechanical termination portion for wires of a cable may be staggered.

The invention improves the RF performance for a three-dimensional circuit board and a counter-contact means with respect to connectors that use a 2D-PCB significantly. The electrical performance improvements in comparison to 2D-PCBs are a clearly better control of a characteristic impedance and better cross-talk compensation possibilities owing to the three-dimensional shape of the circuit board, i. e. the three-dimensional course of its circuit paths.

The mechanical improvements in comparison to 2D-PCBs are a better controllable insertion force, a possibility to prevent staggered electric contact elements (design re-use of existing contact elements), an incorporation of alignment features and, as a result, reduced mechanical tolerances of the entire product, as well as improved cable connection possibilities (e. g. conforming to the shape of the cable).

The invention is especially applicable to all high-speed I/O-card-edge connections. Further, the inventions guarantees full compatibility with existing 2D-PCB technology, i. e. according to the invention 2D-PCBs may be replaced.

The improved characteristic impedance control is further a result of minor tolerances of the three-dimensional circuit board in comparison to a 2D-PCB and a wider range of materials can be chosen compared to PCB technologies. Moreover, a non-uniform thickness of the three-dimensional circuit board provides enhanced impedance control. The cross-talk compensation possibilities are a result of a better alignment of the three-dimensional circuit board, which reduces terminal sizes in an interface zone allowing additional ground layers, and grounded positioning walls. Further, the staggered cable connection mitigates cross-talk.

An additional mechanical advantage is a reduced wear of the contact elements by using a three-dimensional design in a plug portion of the three-dimensional circuit board. Further, mechanical alignment features may be incorporated in a design and overmoulds at the termination portion can be incorporated. A stepped height positioning of the contact elements in the plug portion resolves a need to stagger the contact elements in the counter-contact means to achieve proper normal forces.

Preferred exemplary embodiments of the present invention are explained below in more detail with reference to the accompanying detailed drawing in which:
- Fig. 1: shows a perspective view of a conventional two-dimensional printed circuit board (2D-PCB) in an assembled state with a counter-contact means;
- Fig. 2: shows also in a perspective view an inventive three-dimensional circuit board electrically connected to electric contact elements of a counter-contact means;
- Fig. 3: shows in a top view a detail of a carrier component of the three-dimensional circuit board according to fig. 2 in a middle and an electrical plug area of the carrier component;
- Fig. 4: shows a three-dimensional cutaway lateral view of the three-dimensional circuit board of fig. 2;
- Fig. 5: shows in a perspective view a first embodiment of an arrangement of electrical signal and ground paths at an upper carrier component, thereby omitting an arrangement of electrical paths at a lower carrier component;
- Fig. 6: shows in an analogue view to fig. 5 a second embodiment of an arrangement of signal paths at the upper carrier component;
- Fig. 7: shows again in an analogue view to fig. 5 a third embodiment of an arrangement of signal and ground paths at the upper carrier component;
- Fig. 8: shows a perspective view from above on a front right side of a carrier component comprising a mechanical and an electrical plug portion;
- Fig. 9: shows a perspective view from above on a rearward right side of a carrier component comprising a mechanical and an electrical termination portion; and
- Fig. 10: shows an exploded three-dimensional view of a carcass of a three-dimensional circuit board comprising a central electrical grounding or heat sink sandwiched between two carrier components.

In the following description of the drawing, the invention is explained as an application of a three-dimensional electronic or electric circuit board 1, especially for an electronic, electric or optoelectronic module or unit (not shown), for example for: a connector, a plug, a passive or active cable, a transmitter, a receiver, a transceiver, a GBIC and derivates etc. However, the invention is not restricted to such embodiments. The three-dimensional circuit board is for example applicable for data and/or power transfer with high-speed data transmission rates, especially for an electronic connector or plug.

Preferably the 2D-PCB is replaced by an at least locally plateable plastic component which results in more mechanical and electrical freedom in design. Also a ceramic component is applicable. One way is to replace the 2D-PCB by a three-dimensional circuit board consisting of one, two or more components mechanically connected to each other, and at or in-between them a possibility for one or a plurality of ground layers and/or heat sinks, to resemble to a 2D-PCB.

These ground layers can be made of conductive plates, sheets or strips and may function as a heat sink for active applications, e. g. optics. Another possibility to replace a 2D-PCB is to overmould a metal plate, sheet or strip, which provides a similar structure as the first method. Other three-dimensional circuit boards are of course applicable.

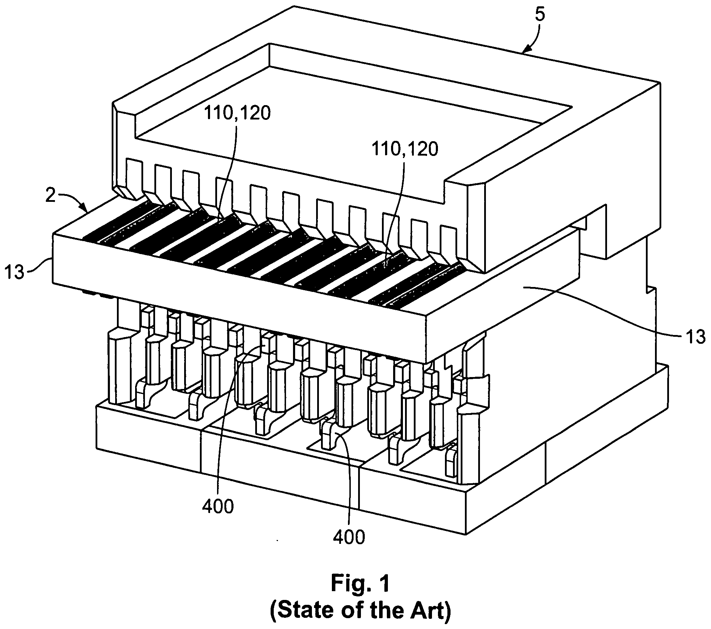

Fig. 1 shows a 2D-PCB 2 according to the state of the art, wherein all circuit paths 110, 120 of the 2D-PCB 2 lie in one plane arranged at a 2D-top side of a substrate of the 2D-PCB 2. An analogue arrangement of circuit paths 110, 120 may be provided at a lower side of the 2D-PCB 2 (not shown in fig. 1). All electrical terminals (not shown in fig. 1) of the 2D-PCB 2 have the same length which is determined by a position tolerance between the terminals and the 2D-PCB 2. Further, all circuit paths 110, 120 and terminals are equidistantly arranged.

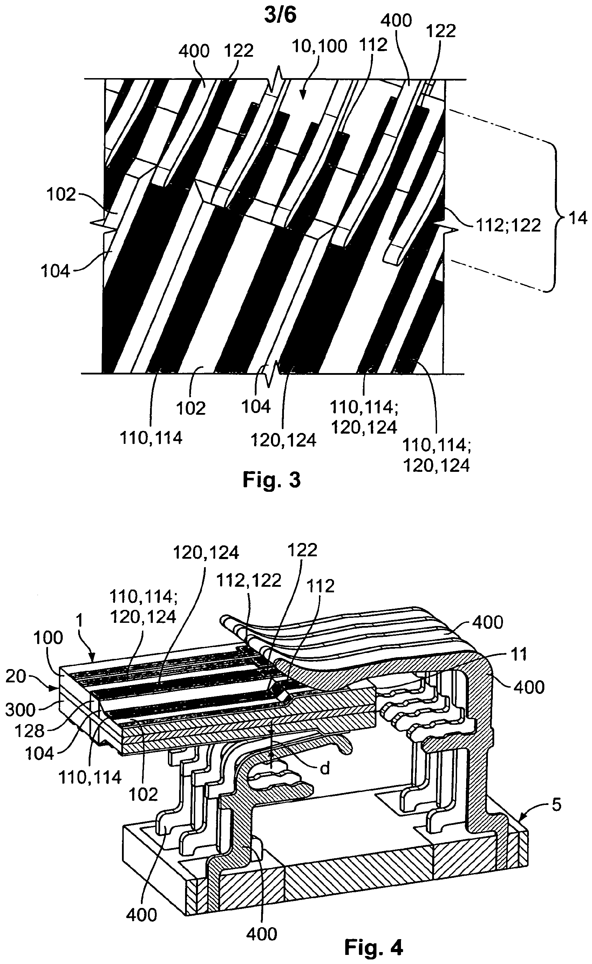

A ground layer (also not shown in fig. 1) of the 2D-PCB does not extend to a side edge 13 of the 2D-PCB 2 to compensate for a large capacitive effect of the comparatively wide terminals. Furthermore, a comparatively small distance between a bottom electric contact element 400 and the circuit paths 110, 120 at a bottom side of the 2D-PCB 2 has a capacitive effect on an impedance profile. (Q. v. the explanations to fig. 4.) Such a 2D-PCB 2 only has severely restricted capacities for improving impedance and/or cross-talk.

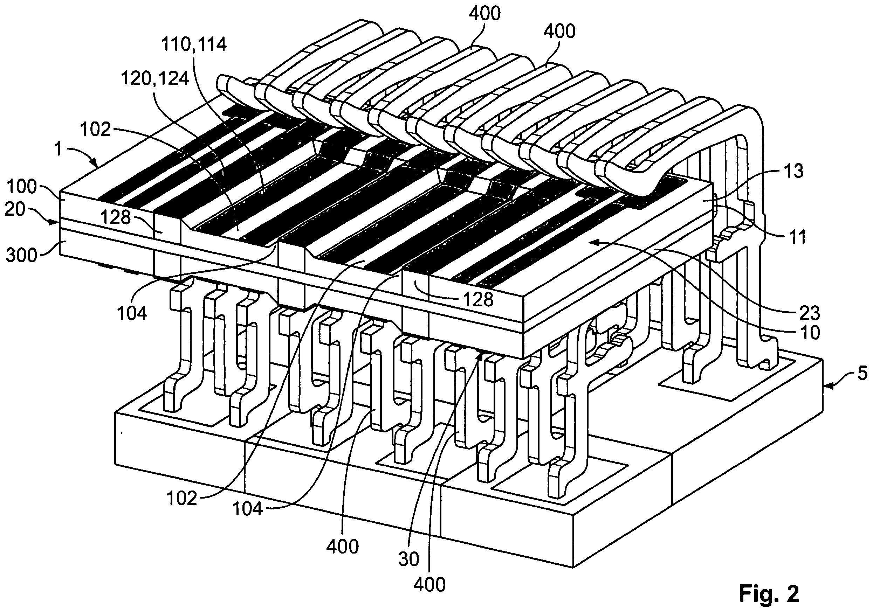

Figures 2 to 10 show embodiments of three-dimensional circuit boards 1 with two carrier components 10, 30 between which a metal plate 20 is arranged, wherein the metal plate 20 may function as an electrical grounding layer and/or as a heat sink. For receiving the metal plate 20 one or both carrier components 10, 30 may comprise a corresponding recess inside. The metal plate 20 may be embodied as a strip.

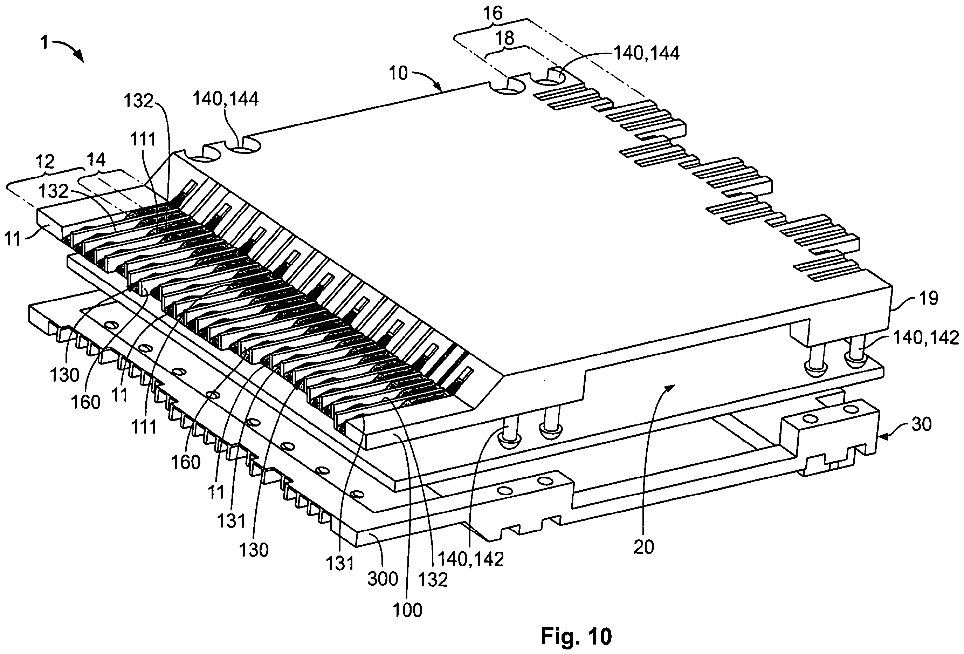

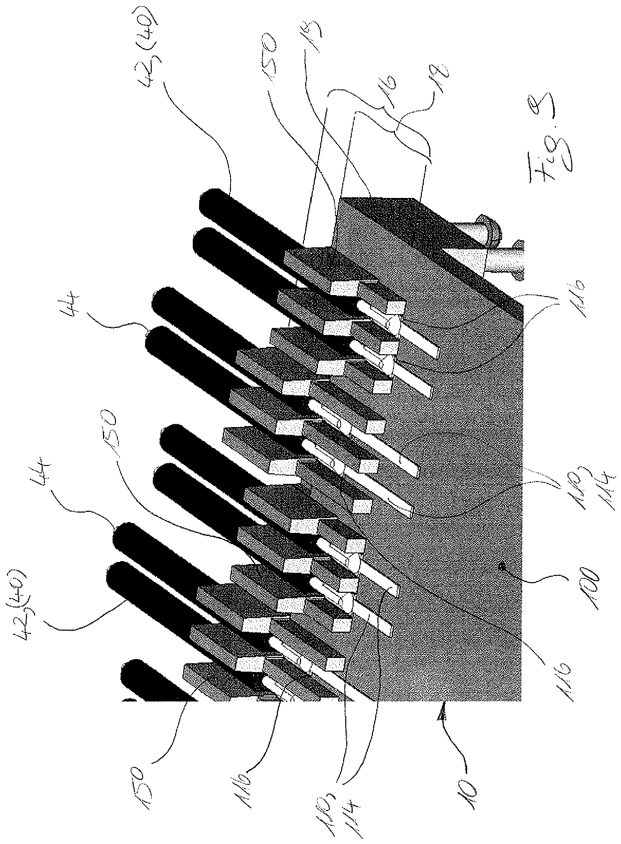

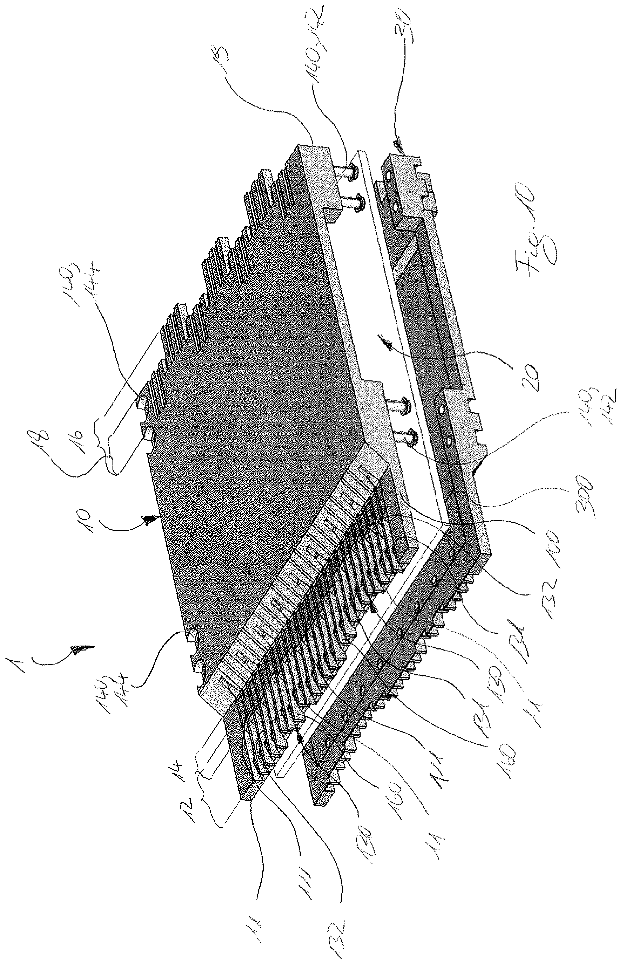

Preferably outside of the metal plate 20 the carrier components 10, 30 may be latched together which is done by corresponding mounting, locking or latching elements 140; 142, 144 which are preferably formed as complementary locking protrusions 142 and locking recesses 144 (cf. fig. 10). Fig. 10 shows only carrier bodies 100, 300 of the carrier components 10, 30 which after plating will carry circuit paths 110, 120 (cf. fig. 2 to 9). Furthermore, fig. 10 shows a cut off carrier body 100 (partially missing mechanical termination portion 16, see below).

The three-dimensional circuit board 1 may for example be processed using a MID process. However, also other processes may be used. During the MID process, on/at/in the carrier body 100, 300 circuit paths 110, 120 were deposited, inserted etc. and the carrier body 100, 300 becomes a complete carrier component 10, 30 - an MID - which functions as a three-dimensional circuit board 1. Here, if applicable, electronic or electric components (not shown), such as an IC, may be provided on the carrier component 10, 30 on every side, for example between two circuit paths 110, 110; 110, 120; 120, 120. According to the invention a second, i. e. a lower carrier component 30 may be constructed analogous or identical to the first, i. e. upper carrier component 10. Therefore, corresponding locking elements 140, 140; 142, 144; 144, 142 are provided in such a way that a flip, reverse or turnaround mounting of the carrier components 10, 30 to one another is possible, cf. fig. 2, wherein two identical carrier bodies 100, 300 for a single three-dimensional circuit board 1 are used.

Hereby, it is especially not necessary that the carrier bodies 100, 300 are identical in their mechanical 12 and/or electrical plug portion 14 and they need not be identical in their mechanical 16 and/or electrical termination portion 18 (see below). Further, a thickness and other constructive features of the carrier bodies 100, 300 of the carrier components 10, 30 may also be differently constructed which especially relates to a course of the circuit paths 110, 120. In particular, the overall carrier bodies 100, 300 of the carrier components 10, 30 do not need to be shaped plate-like.

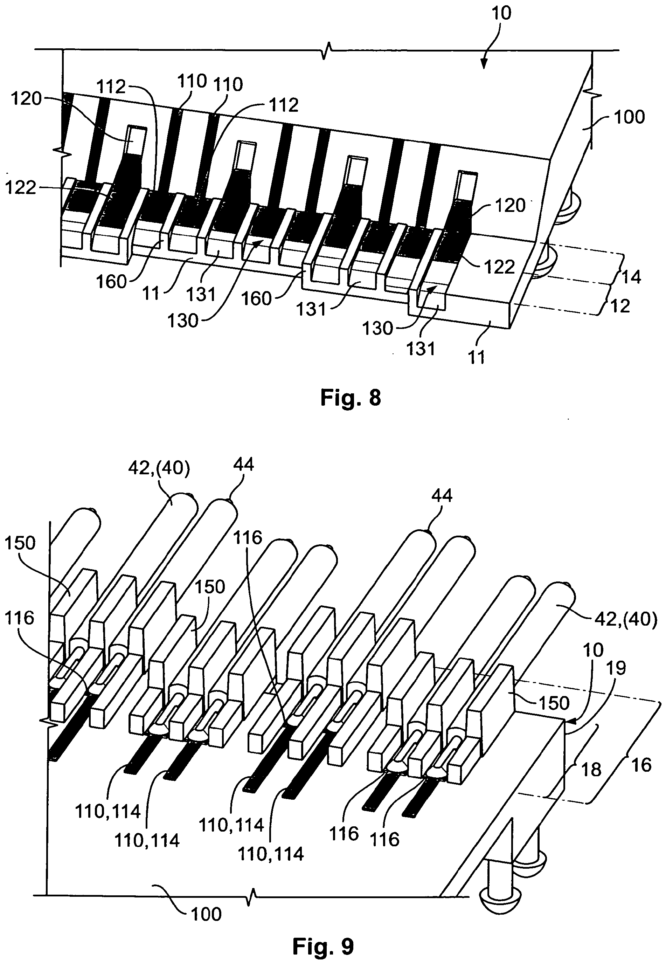

As stated before, a carrier component 10 comprises at a rear end portion (cf. fig. 9) a termination portion 16, 18 comprising a mechanical 16 and an electrical termination portion 18 (seen from rear edge 19). Here, the termination portions 16, 18 of both carrier components 10, 30 constitutes a termination portion for the three-dimensional circuit board 1. Seen from the rear edge 19, the first portion is the mechanical 16 and the portion behind (direction to the front edge 11) is the electrical termination portion 18.

Thereby it is possible that the electrical termination portion 18 is a rear (inner) part of the mechanical termination portion 16. The mechanical termination portion 16 serves as a mechanical positioning of electric wires 42 of an electric cable 40 which is mechanically and electrically attached to the three-dimensional circuit board 1. The electrical termination portion 18 serves as an electrically connection of electric leads 44 of the wires 42 to the carrier component 10. Hereby, the cable 40 comprises a plurality of electric wires 42.

As shown in fig. 9, the mechanical 16 and/or the electrical termination portion 18 may be staggered, wherein two directly adjacent electrical terminals 116 of the carrier component 10 have the same longitudinal position. An adjacent pair thereto is longitudinally offset to the first pair of terminals 116. Here, the terminals 116 are end-portions of signal paths 110 of the three-dimensional circuit board 1. The staggered cable mounting mitigates cross-talk.

Between two directly adjacent terminals 116 a positioning wall 150 may be provided in the mechanical termination portion 16. The positioning wall 150 improves arranging, alignment and holding of the electric wires 42 and reduces cross-talk for the case that they are metallised and preferably grounded. Here, it is preferred that between all terminals 116 positioning walls 150 are provided. It is preferred that the positioning walls 150 between the terminals 116 are lower or removed than the positioning walls 150 between the insulations of the electric wires 42. The lower wall portion is beneficial for soldering of the electric wires 42.

Figures 2 to 4 show an embodiment of the three-dimensional circuit board 1 having two essentially rectangular carrier components 10, 30, wherein the carrier components 10, 30 are preferably constructed identical. For the case of an application of two carrier components into a single three-dimensional circuit board, it is preferred that the second carrier component is designed in an analogue manner to the first carrier component. Here, it is of advantage that the first and the second carrier components are formed identically, or the circuit paths of the first and the second carrier components may be inversely arranged. Between the carrier components 10, 30 the electrical grounding 20 and/or heat sink 20 is arranged, wherein this metal plate 20 extends to an edge 11, 13, 19 of the carrier components 10, 30. Here, the metal plate 20 especially extends to a side edge 13 of the carrier components 10, 30; but also an extension to the front 11 and/or rear edge 19 (see fig. 9 and 10) of the carrier components 10, 30 is possible.

Each carrier component 10, 30 comprises in a middle section a deepening 102 which may be formed as a recess. The deepening 102 defines a lower plane. The essentially rectangular deepening 102 lies preferably centred in the carrier component 10, 30, wherein the deepening 102 is surrounded by a border lying higher than the deepening 102 defining a raising 104. The raising 104 defines an upper plane. Also the deepening 102 may extend over the carrier component 10, 30. A circuit path 110, 120 is arranged at an outside or a surface of the carrier body 100, 300 of the carrier component 10, 30, wherein the circuit path 110, 120 deflects in/through the deepening 102.

As stated before, the carrier component 10, 30 may be an MID which may be manufactured with lesser tolerances than a 2D-PCB 2. Since the mechanical tolerances can be reduced, the electrical terminals 112, 122 may have a shorter length (cf. fig. 3). Further, the width of the circuit paths 110, 120 may vary (see also fig. 3). An impedance control due to height differences (deepening 102) in the 3D circuit board and due to different widths of the circuit paths 110, 120 is possible (the thicker the plastic the wider the terminal must be).

In the state of the art exists only small distances d (not shown in fig. 1) between bottom electrical contacts 400 and bottom circuit paths 110, 120, which has a capacitive effect on an impedance profile of a mated 2D-PCB 2 and a counter-contact means 5. According to the invention the distances d between the bottom electrical contacts 400 and the bottom circuit paths 110, 120 are increased, which improves the impedance. This increasing is a result of the deepening 102; see fig. 4.

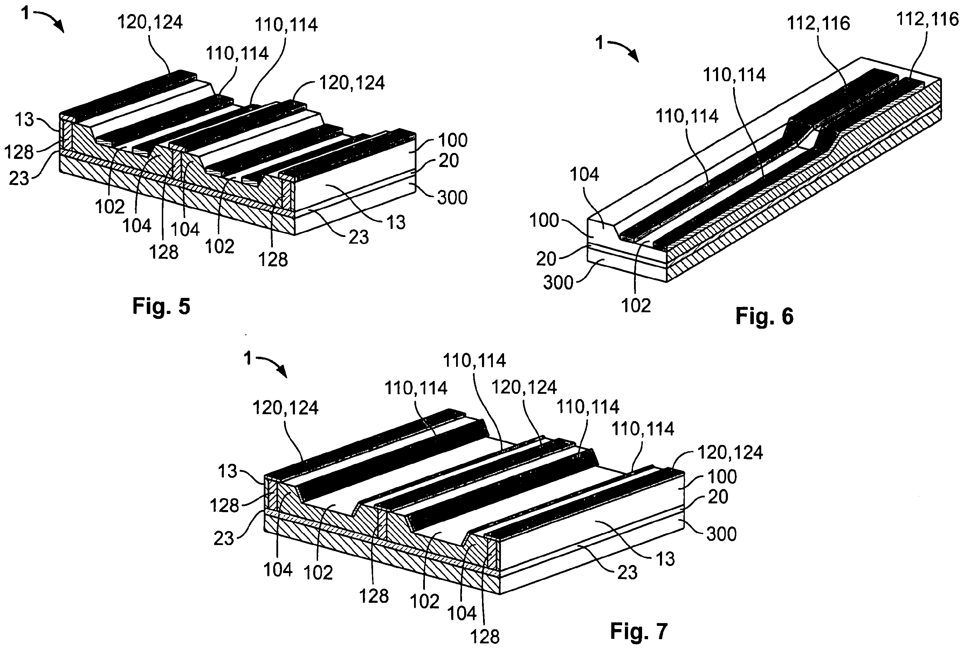

In the comparatively large middle section of the essentially rectangular-shaped carrier component 10 (cf. fig. 2 and 10) there is a freedom in an arrangement of the circuit paths 110, 120, i. e. the signal 110 and/or ground paths 120. The middle section ranges from the terminals 116 or an electrical connection to the electrical grounding 20, to the terminals 112, 122 in the electrical plug portion 14 of the carrier component 10. Some embodiments of such arrangements are shown in fig. 5 to 7, wherein the signal paths 110 and the ground paths 120 may be interchanged.

Fig. 5 shows an increased height of the ground paths 120 in their mid-portions 124. Here, preferably a pair of signal paths 110, i. e. their mid-portions 114, are arranged in the deepening 102, whereas the ground paths 120 are arranged on raisings 104. Preferably, the ground paths 120 are connected via electrical bridges 128 in the carrier body 100 to the electrical grounding 20. The electrical bridges 128 may have the same length as the ground paths 120 and may be arranged in parallel to the electrical bridges 128. Of course it is possible to arrange only one, three or more signal paths 110 in the deepening 102. The electrical bridge may be embodied as a via, a bar, a plated edge or a discrete copper structure.

The signal 110 and the ground paths 120 are inventively provided on different height levels relative to the upper surface of the carrier component 10. This can be realised by, among many other ways, arranging the signal paths 110 in the deepening 102 formed in the surface of the carrier component 10, whereas the ground paths 120 are arranged on the raisings 104 and therefore arranged higher than the signal paths 110.

Fig. 6 shows an increased height of contact areas of the signal paths 110, comprising the terminals 112/116 that are arranged in the upper plane. I. e. the height of the terminals 112/116 may be increased in comparison to the mid-portions 114 of the respective signal path 110. Here, the height of only one terminal 112/116 may be increased in comparison to the mid-portion 114 of its signal path 110. Instead of a signal path 110, also a ground path 120 is applicable. Further, it is possible that one circuit path 110, 120 is broader than an other circuit path 110, 120.

Fig. 7 shows that different trace routing decreases the required width of differential trace, i. e. a width of the deepening 102 may be smaller than a comparable width of the deepening 102 in fig. 3. Hereby, the signal paths 110 are arranged at side walls of the deepening 102, whereas a bottom of the deepening 102 is preferably left free. Especially the side walls are inclined with respect to an even bottom and/or with respect to an even top of the carrier body 100. Here, the signal paths 110 and the ground paths 120 do not lie in parallel planes like in fig. 4. The planes of the signal paths 110 cross the planes of the ground paths 120. Further, two planes of directly adjacent signal paths 110 in one deepening 102 may also cross each other.

The embodiments of figs. 5 and 7 may also comprise a contact area of the signal paths 110 with terminals 112, 116 that are arranged in the upper plane.

Turning now to fig. 8. In the state of the art, the electric contact elements 400 of the counter-contact means 5 are staggered (not shown in fig. 1) to reduce a plugging force of for example a connector. Staggering ensures that all contact elements 400 are not mating at the same time. This staggering is now applied into the three-dimensional circuit board 1, so the electric contact elements 400 of the counter-contact means 5 can be placed in one row (cf. fig. 2 to 4) which simplifies the design of the counter-contact means 5.

Therefore, a front edge 11 of the three-dimensional circuit board 1, i. e. the carrier component 10, is staggered, wherein at least two, preferably more than two steps are provided; cf. fig. 8 and 10 in which three different steps are shown. This also applies to the carrier component 30. The counter-contact means 5 comprises a receptacle which is preferably coded (not shown), wherein inside the receptacle the contact elements 400 are mounted side by side (cf. fig. 1 with fig. 2). The three-dimensional circuit board 1 may be coded accordingly.

As stated before, a carrier component 10 comprises at a front end section (cf. fig. 8 and 10) a plug portion 12, 14 comprising the mechanical 12 and electrical plug portion 14 (seen from front edge 11). In an embodiment of the invention according to fig. 10 the plug portions 12, 14 of two carrier components 10, 30 constitute a plug portion for the three-dimensional circuit board 1. Seen from the front edge 11, the first portion is the mechanical 12 and the portion behind is the electrical plug portion 14. The terminals 112, 122 at the front side of the carrier components 10, 30 preferably lie all in one line being particularly parallel to a plane of the carrier components 10, 30.

When plugging the three-dimensional circuit board 1 and the counter-contact means 5 together, an electric contact element 400 of the counter-contact means 5 has to follow a mechanical path 130 (fig. 8 and 10) of the mechanical plug portion 12. After passing this path 130, the contact element 400 may electrically touch the respective terminal 112, 122. Preferably guiding walls 160 between the mechanical paths 130 ensure guiding of the contact elements 400.

The mechanical path 130 of the carrier component 10 according to fig. 8 comprises at the front edge 11 of the carrier component 10 a preferably bevelled edge 131. After a more or less even path, due to staggering of the mechanical plug portion 12, behind the bevelled edge 131 the respective terminals 112, 122 of the signal 110 and ground paths 120 are provided.

The mechanical path 130 of the carrier component 10 according to fig. 10 comprises behind the bevelled edge 131 a mechanical rest 132 which may be lower than the height of the bevelled edge 131. At the mechanical rest 132, a section (not shown) of the contact element 400 may rest. Farther in the direction to the respective terminal 112, 122 the mechanical path 130 preferably comprises a second bevelled edge 111, wherein the mechanical plug portion 12 migrates into the electrical plug portion 14. Behind the bevelled edge 111, the respective terminal 112, 122 is provided.

The electric contact element 400 is preferably configured as a spring contact. Here, the contact elements 400 for signal paths 110 and ground paths 120, i. e. the respective terminals 112, 122, are preferably identical. Inside the receptacle the contact element 400 is electrically contacted for example to a wire or a circuit path of a PCB. The spring contact 400 comprises a spring section having an electrical contact area for making contact with the respective terminals 112, 122.

### List of reference numerals

- 1: three-dimensional circuit board
- 2: two-dimensional printed circuit board (PCB)
- 5: electronic/electric counter-contact means

- 10: carrier component
- 11: front edge
- 12: mechanical plug portion
- 13: side edge
- 14: electrical plug portion
- 16: mechanical termination portion
- 18: electrical termination portion
- 19: rear edge
- 20: metal plate
- 23: side edge
- 30: carrier component
- 40: electric cable
- 42: electric wire
- 44: electric lead of wire 42

- 100: (first) carrier body
- 102: deepening
- 104: raising, ridge
- 110: circuit path, signal path
- 111: edge, second bevelled edge (mechanical 12 => electrical plug portion 14)
- 112: electrical terminal of signal path 110
- 114: mid-portion of signal path 110
- 116: electrical terminal of signal path 110
- 120: circuit path, ground path
- 122: electrical terminal of ground path 120
- 124: mid-portion of ground path 120
- 128: electrical bridge, ground bridge
- 130: mechanical path of mechanical plug portion 12
- 131: bevelled edge of mechanical plug portion 12
- 132: mechanical rest
- 140: mounting/locking/latching element
- 142: locking protrusion
- 144: locking recess
- 150: positioning wall
- 160: guiding wall
- 300: carrier body
- 400: electric contact element, electric spring contact; signal contact element, ground contact element

- d: distance between bottom electrical contact 400 and bottom circuit path 110, 120

## Claims

1. Three-dimensional circuit board (1), comprising a carrier component (10; 30), carrying at least one circuit path (110, 120) at an outside of a carrier body (100; 300) of the carrier component (10; 30), wherein, for impedance control, the carrier body (100; 300) comprises different planes (102, 104), wherein at least one circuit path (110, 120) is arranged in the different planes (102, 104), **characterised in that**, the three-dimensional circuit board (1) comprises an electrical grounding layer (20) that is arranged below the circuit path (110, 120) and the ground path (120) is connected with an electrical bridge (128) that is guided to the electrical grounding layer (20), and wherein,
for cross-talk control, a mechanical termination portion (16) and/or an electrical termination portion (18) of the carrier component (10; 30) for wires (42) of a cable (40) is staggered, wherein two directly adjacent electrical terminals (116) of the carrier component (10) have the same longitudinal position and an adjacent pair thereto is longitudinally offset to the first pair of terminals (116).

2. The three-dimensional circuit board (1) according to claim 1, **characterized in that** the circuit path (110) comprises an electrical terminal (112, 116) and that the electrical terminal (112, 116) is arranged in the upper plane (104) of the carrier body (110, 300).

3. The three-dimensional circuit board (1) according to the preceding claim, **characterised in that** two circuit paths (110, 110; 110, 120; 120, 120) lie at least partially in the different planes (102, 104).

4. The three-dimensional circuit board (1) according to claim 3, **characterised in that** the planes (102, 104) are inclined or perpendicular to each other.

5. The three-dimensional circuit board (1) according to any of the preceding claims, **characterised in that**, for impedance control a signal path (110) lies at least partially in the lower plane (102) and a ground path (120) lies at least partially in the upper plane (104) of the carrier body (100; 300) .

6. The three-dimensional circuit board (1) according to any of the preceding claims, **characterised in that** a signal path (110) lies at least partially at a side wall of a deepening (102) of the carrier body (100; 300).

7. The three-dimensional circuit board (1) according to any of the preceding claims, **characterized in that** the electrical bridge (128) is embodied as a via or a bar extending along the electrical ground path (120).

8. The three-dimensional circuit board (1) according to any of the preceding claims, **characterised in that**, for cross-talk control, a side edge (23) of the electrical grounding (20) extends essentially to a side edge (13) of the carrier component (10; 30).

9. The three-dimensional circuit board (1) according to any of the preceding claims, **characterised in that**, for cross-talk control, a positioning wall (150) of a wire organiser of the mechanical termination portion (16) is grounded, wherein the positioning wall (150) is electrically conductive.

10. The three-dimensional circuit board (1) according to any of the preceding claims, **characterised in that** the carrier component (10; 30) has a mechanical plug portion (12) and an electrical plug portion (14) arranged one behind the other for mechanically and electrically mating with a counter-contact means (5), that an edge (131) of the mechanical plug portion (12) is staggered, and at least parts of the electrical terminals (112, 122) of the circuit paths (120, 110) lie all in one line with each other.

11. The three-dimensional circuit board (1) of any of the preceding claims, **characterized in that** the carrier body (100, 300) comprises a deepening (102) defining the lower plane and that the carrier body (100, 300) comprises a raising (104) defining the upper plane.

12. Connector for data transfer with high-speed data transmission rates, **characterised in that**,
the connector comprises a three-dimensional circuit board (1) according to any of the claims 1 to 11.

## Patentansprüche

1. Dreidimensionale Leiterplatte (1), umfassend eine Trägerkomponente (10; 30), die mindestens eine Leiterbahn (110, 120) an einer Außenseite eines Trägerkörpers (100; 300) der Trägerkomponente (10; 30) trägt, wobei,
zur Impedanzsteuerung der Trägerkörper (100; 300) verschiedene Ebenen (102, 104) umfasst, wobei mindestens eine Leiterbahn (110, 120) in den verschiedenen Ebenen (102, 104) angeordnet ist, **dadurch gekennzeichnet, dass** die dreidimensionale Leiterplatte (1) eine elektrische Erdungsschicht (20) umfasst, die unterhalb der Leiterbahn (110, 120) angeordnet ist und der Erdungsweg (120) mit einer elektrischen Brücke (128) verbunden ist, die zu der elektrischen Erdungsschicht (20) geführt wird, und wobei, zur Übersprechsteuerung ein mechanischer Anschlussabschnitt (16) und/oder ein elektrischer Anschlussabschnitt (18) der Trägerkomponente (10; 30) für Drähte (42) eines Kabels (40) gestuft ist, wobei zwei direkt benachbarte elektrische Anschlüsse (116) der Trägerkomponente (10) die gleiche Längsposition aufweisen und ein dazu benachbartes Paar in Längsrichtung zum ersten Paar von Anschlüssen (116) versetzt ist.

2. Dreidimensionale Leiterplatte (1) nach Anspruch 1, **dadurch gekennzeichnet, dass** die Leiterbahn (110) einen elektrischen Anschluss (112, 116) umfasst und dass der elektrische Anschluss (112, 116) in der oberen Ebene (104) des Trägerkörpers (110, 300) angeordnet ist.

3. Dreidimensionale Leiterplatte (1) nach dem vorstehenden Anspruch, **dadurch gekennzeichnet, dass** zwei Leiterbahnen (110, 110; 110, 120; 120, 120) zumindest teilweise in den verschiedenen Ebenen (102, 104) liegen.

4. Dreidimensionale Leiterplatte (1) nach Anspruch 3, **dadurch gekennzeichnet, dass** die Ebenen (102, 104) geneigt oder senkrecht zueinander sind.

5. Dreidimensionale Leiterplatte (1) nach einem der vorstehenden Ansprüche, **dadurch gekennzeichnet, dass** zur Impedanzsteuerung ein Signalweg (110) zumindest teilweise in der unteren Ebene (102) und ein Erdungsweg (120) zumindest teilweise in der oberen Ebene (104) des Trägerkörpers (100; 300) liegt.

6. Dreidimensionale Leiterplatte (1) nach einem der vorstehenden Ansprüche, **dadurch gekennzeichnet, dass** ein Signalweg (110) zumindest teilweise an einer Seitenwand einer Vertiefung (102) des Trägerkörpers (100; 300) liegt.

7. Dreidimensionale Leiterplatte (1) nach einem der vorstehenden Ansprüche, **dadurch gekennzeichnet, dass** die elektrische Brücke (128) als Durchkontaktierung oder Schiene ausgebildet ist, die sich entlang des elektrischen Erdungsweges (120) erstreckt.

8. Dreidimensionale Leiterplatte (1) nach einem der vorstehenden Ansprüche, **dadurch gekennzeichnet, dass** sich zur Übersprechsteuerung eine Seitenkante (23) der elektrischen Erdung (20) im Wesentlichen bis zu einer Seitenkante (13) der Trägerkomponente (10; 30) erstreckt.

9. Dreidimensionale Leiterplatte (1) nach einem der vorstehenden Ansprüche, **dadurch gekennzeichnet, dass** zur Übersprechsteuerung eine Positionierungswand (150) eines Drahtorganizers des mechanischen Anschlussabschnitts (16) geerdet ist, wobei die Positionierungswand (150) elektrisch leitfähig ist.

10. Dreidimensionale Leiterplatte (1) nach einem der vorstehenden Ansprüche, **dadurch gekennzeichnet, dass** die Trägerkomponente (10; 30) einen mechanischen Steckerabschnitt (12) und einen elektrischen Steckerabschnitt (14) aufweist, die zum mechanischen und elektrischen Zusammenfügen mit einem Gegenkontaktmittel (5) hintereinander angeordnet sind, dass eine Kante (131) des mechanischen Steckerabschnitts (12) gestuft ist und zumindest Teile der elektrischen Anschlüsse (112, 122) der Leiterwege (120, 110) alle in einer Linie liegen.

11. Dreidimensionale Leiterplatte (1) nach einem der vorstehenden Ansprüche, **dadurch gekennzeichnet, dass** der Trägerkörper (100, 300) eine Vertiefung (102) umfasst, die die untere Ebene definiert, und dass der Trägerkörper (100, 300) eine Anhebung (104) umfasst, die die obere Ebene definiert.

12. Steckverbinder zur Datenübertragung mit hohen Datenübertragungsraten, **dadurch gekennzeichnet, dass** der Steckverbinder eine dreidimensionale Leiterplatte (1) nach einem der Ansprüche 1 bis 11 umfasst.

## Revendications

1. Carte de circuit imprimé tridimensionnelle (1), comprenant un composant de support (10 ; 30), portant au moins un chemin de circuit (110, 120) au niveau d'une partie extérieure d'un corps de support (100 ; 300) du composant de support (10 ; 30), dans laquelle,
pour la commande d'impédance, le corps de support (100 ; 300) comprend différents plans (102, 104), au moins un chemin de circuit (110, 120) étant agencé dans les différents plans (102, 104), **caractérisée en ce que**,
la carte de circuit imprimé tridimensionnelle (1) comprend une couche de mise à la masse électrique (20) qui est agencée au-dessous du chemin de circuit (110, 120) et le chemin de masse (120) est connecté à un pont électrique (128) qui est guidé vers la couche de mise à la masse électrique (20), et dans laquelle,
pour la commande de diaphonie, une partie de terminaison mécanique (16) et/ou une partie de terminaison électrique (18) du composant de support (10 ; 30) pour les fils (42) d'un câble (40) sont étagées, deux bornes électriques directement adjacentes (116) du composant de support (10) ayant la même position longitudinale et une paire adjacente à celles-ci étant longitudinalement décalée de la première paire de bornes (116).

2. Carte de circuit imprimé tridimensionnelle (1) selon la revendication 1, **caractérisée en ce que** le chemin de circuit (110) comprend une borne électrique (112, 116) et **en ce que** la borne électrique (112, 116) est agencée dans le plan supérieur (104) du corps de support (110, 300).

3. Carte de circuit imprimé tridimensionnelle (1) selon la revendication précédente, **caractérisée en ce que** deux chemins de circuit (110, 110 ; 110, 120 ; 120, 120) reposent au moins partiellement dans les différents plans (102, 104).

4. Carte de circuit imprimé tridimensionnelle (1) selon la revendication 3, **caractérisée en ce que** les plans (102, 104) sont inclinés ou perpendiculaires entre eux.

5. Carte de circuit imprimé tridimensionnelle (1) selon l'une quelconque des revendications précédentes, **caractérisée en ce que**, pour la commande d'impédance, un chemin de signal (110) repose au moins partiellement dans le plan inférieur (102) et un chemin de masse (120) repose au moins partiellement dans le plan supérieur (104) du corps de support (100 ; 300).

6. Carte de circuit imprimé tridimensionnelle (1) selon l'une quelconque des revendications précédentes, **caractérisée en ce qu'**un chemin de signal (110) repose au moins partiellement au niveau d'une paroi latérale d'un creusement (102) du corps de support (100 ; 300).

7. Carte de circuit imprimé tridimensionnelle (1) selon l'une quelconque des revendications précédentes, **caractérisée en ce que** le pont électrique (128) est mis en oeuvre sous la forme d'un trou d'interconnexion ou d'une barre s'étendant le long du chemin de masse électrique (120).

8. Carte de circuit imprimé tridimensionnelle (1) selon l'une quelconque des revendications précédentes, **caractérisée en ce que**, pour la commande de diaphonie, un bord latéral (23) de la mise à la masse électrique (20) s'étend pratiquement vers un bord latéral (13) du composant de support (10 ; 30).

9. Carte de circuit imprimé tridimensionnelle (1) selon l'une quelconque des revendications précédentes, **caractérisée en ce que**, pour la commande de diaphonie, une paroi de positionnement (150) d'un élément d'organisation de fils de la partie de terminaison mécanique (16) est mise à la masse, la paroi de positionnement (150) étant électroconductrice.

10. Carte de circuit imprimé tridimensionnelle (1) selon l'une quelconque des revendications précédentes, **caractérisée en ce que** le composant de support (10 ; 30) possède une partie fiche mécanique (12) et une partie fiche électrique (14) agencées l'une derrière l'autre pour un accouplement mécanique et électrique avec un moyen de contre-contact (5), **en ce qu'**un bord (131) de la partie fiche mécanique (12) est étagé, et au moins des parties des bornes électriques (112, 122) des chemins de circuit (120, 110) reposent toutes alignées les unes sur les autres.

11. Carte de circuit imprimé tridimensionnelle (1) selon l'une quelconque des revendications précédentes, **caractérisée en ce que** le corps de support (100, 300) comprend un creusement (102) définissant le plan inférieur et **en ce que** le corps de support (100, 300) comprend une surélévation (104) définissant le plan supérieur.

12. Connecteur pour un transfert de données avec des débits de transmission de données élevés, **caractérisé en ce que**
le connecteur comprend une carte de circuit imprimé tridimensionnelle (1) selon l'une quelconque des revendications 1 à 11.
